# EUROPEAN PATENT APPLICATION

(11) **EP 4 404 282 A2**
(43) Date of publication of application: **24.07.2024**
(21) Application number: 24179874.3
(22) Date of filing: 02.07.2012
(51) Int. Cl.: H01L 31/0747

(54) **METHOD OF MANUFACTURING A HETERO-JUNCTION SOLAR CELL**

(62) Divisional of application: 21150107.7
(71) Applicant: Meyer Burger (Germany) GmbH, 09337 Hohenstein-Ernstthal (DE)
(72) Inventor: Papet, Pierre, 2068 Hauterive (CH); Lachenal, Damien, 2022 Bevaix (CH)
(74) Representative: Steiniger, Carmen

(57) **Abstract**

The invention relates to a hetero-junction solar cell with edge isolation, having a front side for an incidence of light into the solar cell and a back side opposite to the front side and comprising: a doped and textured semiconductor substrate, said semiconductor substrate having a front surface and a back surface opposite to each other and an edge surrounding the semiconductor substrate; at least one front layer on the front surface of the semiconductor substrate, said at least one front layer containing semiconductor atoms or molecules being arranged in amorphous and/or microcrystalline and/or oxide and/or carbide phase; at least one back layer on the back surface of the semiconductor substrate, said at least one back layer containing semiconductor atoms or molecules being arranged in amorphous and/or microcrystalline and/or oxide and/or carbide phase; an electrically conductive anti-reflection coating on the at least one front layer, said anti-reflection coating covering the whole surface of the at least one front layer and being at least partially transparent to the light irradiating into the solar cell; an electrically conductive back coating on the at least one back layer; and a front grid metallization on the anti-reflection coating. the conductive back coating is formed on the surface of the at least one back layer with a distance to the edge of the semiconductor substrate, leaving a merging region consisting of a margin area of the surface of the at least one back layer and the edge of the semiconductor substrate free from the conductive back coating, wherein there is no electrical contact between the conductive back coating and the conductive anti-reflection coating at all during the whole process of formation of the conductive back coating. According to the invention, the at least one back layer is one layer or a stack of layers forming a back surface field or a back emitter of the solar cell, wherein a part of said at least one back layer overlaps the edge, and wherein a part of said at least one back layer overlaps the at least one front layer, and said electrically conductive anti-reflection coating covers the whole surface of the at least one front layer.

## Description

The present invention relates to a method of manufacturing a hetero-junction solar cell, the solar cell having a front side for an incidence of light into the solar cell and a back side opposite to the front side. The method includes the steps of: providing a doped and textured semiconductor substrate, said semiconductor substrate having a front surface and a back surface opposite to each other and an edge surrounding the semiconductor substrate; forming at least one front layer on the front surface of the semiconductor substrate, said at least one front layer containing semiconductor atoms or molecules being arranged in amorphous and/or microcrystalline and/or oxide and/or carbide phase; forming at least one back layer on the back surface of the semiconductor substrate, said at least one back layer containing semiconductor atoms or molecules being arranged in amorphous and/or microcrystalline and/or oxide and/or carbide phase; forming an electrically conductive anti-reflection coating on the at least one front layer, said anti-reflection coating covering the whole surface of the at least one front layer and being at least partially transparent to the light irradiating into the solar cell; forming an electrically conductive back coating on the at least one back layer; and forming a front grid metallization on the anti-reflection coating. The invention further relates to an accordant edge isolated hetero-junction solar cell.

Methods and accordant hetero-junction solar cells with of that type are known in different variants in the state of the art. Conventional hetero-junction solar cells are formed from an n-type doped substrate wherein a p-type doped emitter is formed on a front side of this substrate. That front side corresponds to the face where sun light mainly introduces into the solar cell. Fabrication of this type of solar cell involves deposition of the p-doped emitter layer on the front side of the substrate and deposition of an n-doped layer forming a back surface field on the back side of the substrate. In other solar cells, the type of doping used for the substrate and the doped layers can be the opposite way round. Moreover, it is also possible to place the emitter on the back side of the substrate and to form a front surface field layer on the front side of the substrate.

To improve cell performances, intrinsic layers can be used between the substrate and the doped layers. The doped and intrinsic layers can be of any type of material. Most commonly, these layers are based on silicon in an amorphous and/or microcrystalline and/or oxide and/or carbide phase.

In hetero-junction solar cells, it is necessary to prevent an electrical short circuit between the electrically conductive layers on the front and on the back side of the solar cell. Since such an undesired short circuit is typically formed around the edges, that means the side surfaces, of the semiconductor substrate used, the methods for preventing such short circuits are referred to as edge isolation methods. In the state of the art, there are different technologies knows to provide an edge isolation of hetero-junction solar cells.

The document US 5,935,344 A describes a method for edge isolation of hetero-junction solar cells using a structuring of the electrical conductive films on the front side or on the back side of the solar cell by laser drilling. In result of this structuring, a trench is formed at a peripheral portion of the front side or of the back side of the solar cell, the trench going at least through the respective transparent conductive film and the respective doped amorphous silicon layer. The trench surrounds continuously the laminated body of electrical conductive layers formed on the front side or on the back side of the solar cell. Alternatively, the document suggests to remove all deposited layers at the side surfaces of the substrate or to expose the side surfaces of the substrate at least partially by forming a continuous trench around the side surfaces of the substrate by laser irradiation. This technology includes the risk of creation of damages of the certain substrate regions and layers of the solar cell by the impact of the laser. Structuring of the front transparent conductive film, as it is suggested in one embodiment of this document, leads, moreover, to a decreased cell performance.

Another method of edge isolation of solar cells is disclosed in the document WO 2012/059878 A1. During manufacturing of the proposed solar cell, a narrow line of coating is applied along cell edge on one side or on both sides or on the edge of the solar cell prior to depositing electrically conductive films on the front and/or the back side of the solar cell. After the deposition of the conductive films, the narrow line of coating is removed by a wet or dry processing step. Thus, an interruption of the electrical conductive layers on the front and/or the back side of the solar cell can be realized for preventing of short circuits between the front and the back side of the solar cell. Although this method is very effective, it requires first a very sensible, local formation of the thin, narrow line at the edge of the substrate which is not easy to handle and second a removal of that narrow line being under the conductive film bearing the risk of an unintentional removal of further, alongside parts of the conductive film.

It is therefore the object of the present invention to provide an easy and low-cost method of manufacturing of a hetero-junction solar cell and an according solar cell, wherein short circuits between the front and the back side of the solar cell are prevented and the solar cell is not damaged by the method steps and shows good cell performance.

This object is solved by a method of the above mentioned type, wherein the conductive back coating is formed on the surface of the at least one back layer with a distance to the edge of the semiconductor substrate, leaving a merging region consisting of a margin area of the surface of the at least one back layer and the edge of the semiconductor substrate free from the conductive back coating, wherein there is no electrical contact between the conductive back coating and the conductive anti-reflection coating at all during the whole process of formation of the conductive back coating.

In the method of the present invention, already during the one step of forming the electrically conductive back coating all requirements for a prevention of short circuits between the front and the back side of the solar cell are fulfilled. By forming the electrically conductive back coating only in a middle part of the substrate leaving a margin to the edge of the substrate free, the conductive back coating does neither cover nor overlap over the side surfaces of the substrate and comes therefore not in contact with a conductive layer on the front side of the solar cell. The method of the present invention uses for this effect conventional process steps, like a deposition through a mask, which have no damaging influence on the solar cell substrate or its layers. The edge isolation method of the present invention can be easily implemented in the solar cell process flow without extra cost. Thus, an easy and low-cost but very reliable and effective method for edge isolation of hetero-junction solar cells can be provided by the present invention.

The method of the present invention involves no structuring of the transparent conductive layer(s) on front of the solar cell. Without this front side structuring, the cell front area is larger and allows collecting more light and generating more current. Moreover, the uniform front transparent conductive film (anti-reflection coating) provides a better cell appearance for module integration.

The edge isolation method of the present invention is only effective if the cell fabrication steps used are realized in a defined order. It is in particular advantageous if the at least one front layer is formed prior to forming of the at least one back layer. This sequence is not usual. If the formation of the at least one back layer would be performed before the formation of the at least one front layer, there would be a high risk of shunts on the cell edge.

In a variant of the method of the present invention, the conductive back coating is formed with a distance of 5 µm to 10 mm from the edge of the semiconductor substrate.

In a further improved embodiment of the present invention, the conductive back coating is formed with a distance of 30 µm to 3 mm from the edge of the semiconductor substrate.

It is especially beneficial if the conductive back coating is deposited on the surface of the at least one back layer through a shadow mask having a opening being adapted to the dimensions of the semiconductor substrate, but smaller, and having a cover region around this opening covering at least the margin area of the surface of the at least one back layer during deposition. The physical mask covers this way the substrate's edge during the deposition of the conductive back coating. The mask is, for instance, able to protect few micrometers to millimeters to the cell edge from the film deposition. The mask can be easily integrated in a carrier holder of a deposition tool. With this method, edge isolation can be performed during the back side conductive film deposition without the need of an extra step to perform the edge isolation. This leads to a reduction of process steps reducing the final cell costs.

In accordance with another option of the present invention, the conductive back coating is deposited on the whole surface of the at least one back layer, followed by a removal of a rim of the conductive back coating.

The removal of the rim of the conductive back coating can be done by chemical etching and/or lift-off and/or laser ablation of the rim of the conductive back coating.

The object is further solved by a hetero-junction solar cell with a front side for an incidence of light into the solar cell and a back side opposite to the front side, the solar cell comprising: a doped and textured semiconductor substrate, said semiconductor substrate having a front surface and a back surface opposite to each other and an edge surrounding the semiconductor substrate; at least one front layer formed on the front surface of the semiconductor substrate, said at least one front layer containing semiconductor atoms or molecules being arranged in amorphous and/or microcrystalline and/or oxide and/or carbide phase; at least one back layer formed on the back surface of the semiconductor substrate, said at least one back layer containing semiconductor atoms or molecules being arranged in amorphous and/or microcrystalline and/or oxide and/or carbide phase; an electrically conductive anti-reflection coating formed on the at least one front layer, said anti-reflection coating covering the whole surface of the at least one front layer and being at least partially transparent to the light irradiating into the solar cell; an electrically conductive back coating formed on the at least one back layer; a front grid metallization formed on the anti-reflection coating; and a back electrode formed on the conductive back coating; wherein the conductive back coating is formed on the surface of the at least one back layer with a distance to the edge of the semiconductor substrate, leaving a merging region consisting of a margin area of the surface of the at least one back layer and the edge of the semiconductor substrate free from the conductive back coating, wherein there is no electrical contact between the conductive back coating and the conductive anti-reflection coating at all.

The hetero-junction solar cell of the present invention can be produced without structuring of the front transparent conductive film forming the anti-reflection coating of the solar cell. This allows better light collection and cell performances with a homogeneous front side appearance of the solar cell having no color gradient of the anti-reflection coating on the edge of the solar cell.

In a favorable embodiment of the hetero-junction solar cell of the present invention, the at least one back layer overlaps the at least one front layer. That leads to the effect that there is formed a horizontal structure of an n-/p-/n- or a p-/n-/p-layer-stack on the cell edge acting as two diodes in opposition that block current flow in lateral direction.

Exemplarily, the conductive back coating has a distance of 5 µm to 10 mm from the edge of the semiconductor substrate. This results in a very sure electrical isolation of the front side and the back side of the hetero-junction solar cell of the present invention.

A favorable embodiment of the method of the present invention is explained in the following with reference to the drawings in which
- Fig. 1: schematically shows a semiconductor substrate used for manufacturing a hetero-junction solar cell in accordance with the present invention in a sectional view;
- Fig. 2: schematically shows the substrate of Fig. 1 being covered by at least one front layer on a front surface of the semiconductor substrate;
- Fig. 3: schematically shows the structure of Fig. 2 being covered by at least one back layer on a back surface of the semiconductor substrate;
- Fig. 4: schematically shows the structure of Fig. 3 being coated by an electrically conductive anti-reflection coating formed on the at least one front layer;
- Fig. 5: schematically shows the structure of Fig. 4 wherein an electrically conductive back coating is deposited through a mask on the at least one back layer;
- Fig. 6: schematically shows the structure of Fig. 5 with removed mask;
- Fig. 7: schematically shows a hetero-junction solar cell being formed from the structure of Fig. 6 plus forming a front grid metallization and a back electrode;
- Fig. 8: corresponds to Fig. 7 with added charges illustrating the charge distribution at the front side, on the back side and on the edge of the hetero-junction solar cell; and
- Fig. 9: schematically shows the stack of layers present on the edge of the heterojunction solar cell of Fig. 8.

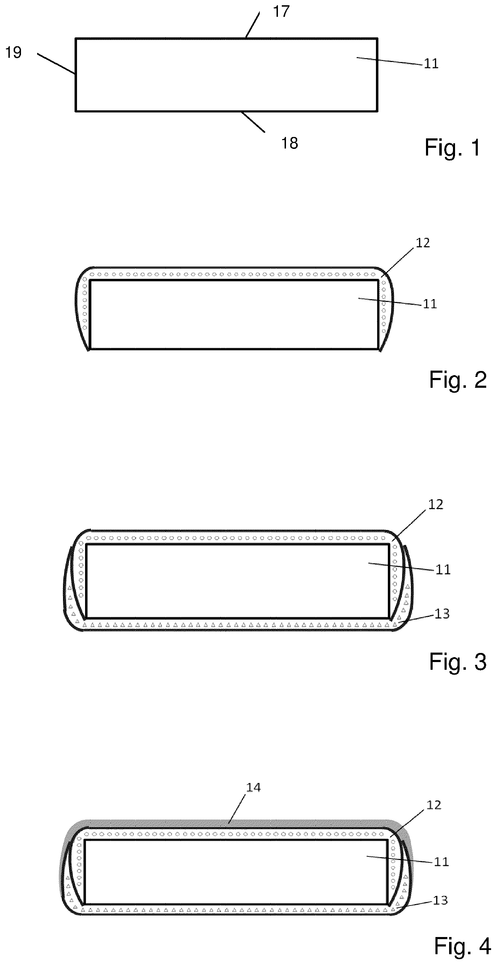

Figs. 1 to 7 schematically show an advantageous sequence of process steps of the method of the present invention resulting in a hetero-junction solar cell 1 according to the present invention. The steps shown in the Figs. 1 to 7 are only representative figures showing characteristic but not all details of the process used.

As shown in Fig. 1, the method of the present invention starts with a semiconductor substrate 11. The semiconductor substrate 11 can consist of any semiconductive material that can have any size and doping. The semiconductor substrate 11 is in the embodiment shown of a crystalline semiconductor material, preferably of monocrystalline or multi-crystalline silicon. The semiconductor substrate 11 is doped. The doping can be of n-type or of p-type, dependent from the kind of solar cell to be produced. The semiconductor substrate 11 has a front surface 17 for an incidence of most of the light and a back surface 18 opposite to the front surface 17. The front surface 17 of the semiconductor substrate 11 is textured to decrease a reflection of light received. Moreover, the semiconductor substrate 11 has an edge 19 surrounding the bulk of the semiconductor substrate 11 and extending between the front surface 17 and the back surface 18 of the semiconductor substrate 11. The edge 19 is only schematically shown and is not necessarily flat as shown in Fig. 1, but can also be convex or pointed. As usual in semiconductor technologies, the semiconductor substrate 11 is cleaned. Cleaning steps are made before and/or after the following method steps, too, and are not especially mentioned in each case.

With reference to Fig. 2, in a next step of the method of the present invention, at least one front layer 12 is formed on the front surface 17 of the semiconductor substrate 11. The at least one front layer 12 can be one layer or a stack of layers. The at least one front layer 12 can also cover at least a part of the edge 19 of the semiconductor substrate 11. The at least one front layer 12 contains semiconductor atoms or molecules being arranged in amorphous and/or microcrystalline and/or oxide and/or carbide phase. For instance, the at least one front layer 12 can consist of an intrinsic silicon layer formed directly on the front surface 17 of the semiconductor substrate 11 and a doped amorphous silicon layer, such as a p-doped amorphous silicon layer, formed on the intrinsic layer. In other embodiments of the invention, that intrinsic layer can be omitted. The at least one front layer 12 is preferably deposited by PECVD (plasma enhanced physical vapor deposition). The at least one front layer 12 has typically a thickness of less than 50 nm. Depending on the type of solar cell to be produced, the at least one front layer 12 will form an emitter or a front surface field of the solar cell.

As demonstrated in Fig. 3, in a further step of the method of the present invention, at least one back layer 13 is formed on the back surface 18 of the semiconductor substrate 11. In the shown embodiment of the method of the present invention, the at least one back layer 13 is explicitly formed after the formation of the at least one front layer 12. The at least one back layer 13 can be one layer or a stack of layers. The at least one back layer 13 is preferably deposited by PECVD (plasma enhanced physical vapor deposition). The at least one back layer 13 has typically a thickness of less than 50 nm. The at least one back layer 13 can also cover at least a part of the edge 19 of the semiconductor substrate 11 and/or can also cover at least a part of the at least one front layer 12 that overlaps the edge 19 of the semiconductor substrate 11.

The at least one back layer 13 contains semiconductor atoms or molecules being arranged in amorphous and/or microcrystalline and/or oxide and/or carbide phase. For instance, the at least one back layer 13 can consist of an intrinsic silicon layer formed directly on the back surface 18 of the semiconductor substrate 11 and a doped amorphous silicon layer, such as an n⁺-doped amorphous silicon layer, formed on the intrinsic layer. In other embodiments of the invention, that intrinsic layer can be omitted. Depending on the type of solar cell to be produced, the at least one back layer 13 will form a back surface field or a back emitter.

In the method step shown in Fig. 4, an electrically conductive anti-reflection coating 14 is formed on the at least one front layer 12. The anti-reflection coating 14 is at least partially transparent to the light irradiating into the solar cell. For instance, many transparent conductive oxides, such as indium oxide or indium tin oxide, can be used as material for the anti-reflection coating 14. The anti-reflection coating 14 covers at least the whole surface of the at least one front layer 12. The anti-reflection coating 14 can also cover at least a part of the edge 19 of the semiconductor substrate 11 and/or at least a part of the at least one back layer 13 overlapping the edge 19 and/or at least a part of the at least one front layer 12 overlapping the edge 19.

Since, as mentioned above, the edge 19 of the semiconductor substrate 11 can be covered with a variable combination of layers being part of the at least one front layer 12 and/or the at least one back layer 13 and/or the anti-reflection coating 14, in the following as well as in the claims the expression "edge 19" should be understood as to be the whole surrounding side surface(s) of the semiconductor substrate 11 with and/or without these additional layers or parts of layers.

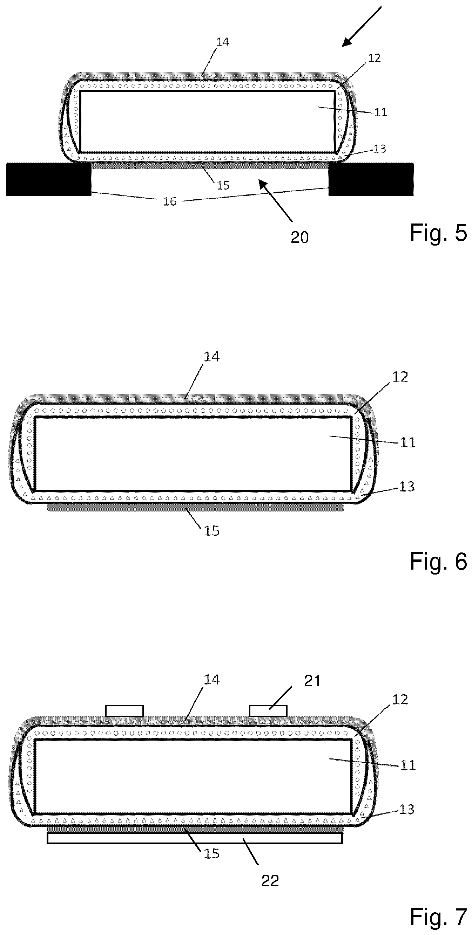

In a next step of the method of the present invention shown in Fig. 5, a mask 16 is provided on the back side of the structure. The mask 16 is a shadow mask has a cover region that covers the edge 19 of the semiconductor substrate 11 as well as a margin of the at least one back layer 13. In its middle region, the mask has an opening 20. The shape of the opening 20 is adapted to the shape of the semiconductor substrate 11, but has smaller dimensions. The margin can, for instance, have a radial dimension of a few micrometers to a few millimeters, such as of about 5 µm to about 10 mm, preferably of about 30 µm to 3 mm, measured from the edge 19 of the semiconductor substrate 11. Through the opening 20 of the mask 16, an electrically conductive back coating 15 is deposited on the surface of the at least one back layer 13. Due to the mask 16, the electrically conductive back coating 15 is formed only on the surface of the at least one back layer 13 with a distance to the edge 19 of the semiconductor substrate 11, leaving a merging region consisting of a margin area of the surface of the at least one back layer 13 and the edge 19 of the semiconductor substrate 11 free from the conductive back coating 15. There is no electrical contact between the conductive back coating 15 and the conductive anti-reflection coating 14 at all during the whole process of formation of the conductive back coating 15. The area covered by the conductive back coating 15 should be maximized without being in contact with the anti-reflection coating 14.

The anti-reflection coating 14 and the conductive back coating 15 can be deposited in any order or at the same time.

The conductive back coating 15 can be formed by transparent conductive film(s) and/or metallic film(s). The conductive back coating 15 film(s) can be deposited by sputtering or evaporation techniques.

In other embodiments of the present invention, the step of Fig. 5 can be replaced by two sub-steps wherein in a first sub-step the conductive back coating 15 is deposited on the surface of the at least one back layer 13. During deposition of the conductive back-coating 15, an electrical contact between the conductive back coating 15 and the anti-reflection coating 14 has to be avoided. In a second sub-step, a rim of the conductive back coating 15 is removed. The removal of that rim of the conductive back coating 15 can be done by chemical etching and/or lift-off of the rim and/or laser ablation.

Fig. 6 schematically shows the structure of Fig. 5 after removal of the mask 16.

As schematically shown in Fig. 7, the method of manufacturing a hetero-junction solar cell 1 in according with the present invention ends with forming a front grid metallization 21. In some cases, in an additional step, a back electrode 22 is formed by a metallization of the back side of the conductive back coating 15.

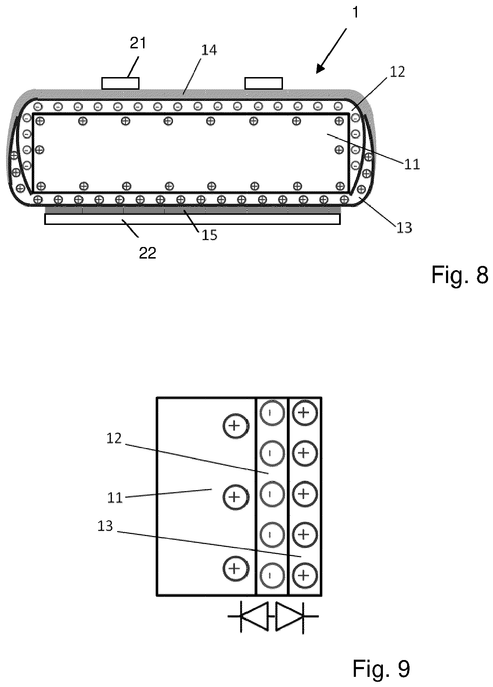

Fig. 8 corresponds to Fig. 7 with added charges illustrating the charge distribution at the front side, on the back side and on the edge 19 of the hetero-junction solar cell 1, wherein in the example shown the semiconductor substrate 11 is n-doped, the at least one front layer 12 is p-doped and the at least one back layer 13 is n-doped.

Fig. 9 schematically shows the stack of layers 11, 12, 13 present on the edge 19 of the hetero-junction solar cell 1 of Fig 8. The horizontal structure n/(i)p/(i)n provided by the n-doped semiconductor substrate 11, the p-doped at least one front layer 12 (emitter) and the n-doped at least one back layer 13 (back surface field) acts as two diodes in opposition blocking a current flow in lateral direction. If the at least one back layer 13 would be formed prior to forming of the at least one front layer 12, that would lead to a shunt.

## Claims

1. Hetero-junction solar cell (1) with a front side for an incidence of light into the solar cell (1) and a back side opposite to the front side, the solar cell (1) comprising:
- a doped and textured semiconductor substrate (11), said semiconductor substrate (11) having a front surface (17) and a back surface (18) opposite to each other and an edge (19) surrounding the semiconductor substrate (11);
- at least one front layer (12) formed on the front surface (17) of the semiconductor substrate (11), said at least one front layer (12) containing semiconductor atoms or molecules being arranged in amorphous and/or microcrystalline and/or oxide and/or carbide phase, wherein said at least one front layer (12) forms an emitter or a front surface field of the solar cell (1);
- at least one back layer (13) formed on the back surface (18) of the semiconductor substrate (11), said at least one back layer (13) containing semiconductor atoms or molecules being arranged in amorphous and/or microcrystalline and/or oxide and/or carbide phase;
- an electrically conductive anti-reflection coating (14) formed on the at least one front layer (12), said anti-reflection coating (14) being at least partially transparent to the light irradiating into the solar cell (1);
- an electrically conductive back coating (15) formed on the at least one back layer (13); and
- a front grid metallization formed on the anti-reflection coating (14);
wherein the conductive back coating (15) is formed on the surface of the at least one back layer (13) with a distance to the edge (19) of the semiconductor substrate (11), leaving a merging region consisting of a margin area of the surface of the at least one back layer (13) and the edge (19) of the semiconductor substrate (11) free from the conductive back coating (15), wherein there is no electrical contact between the conductive back coating (15) and the conductive anti-reflection-coating (14) at all,
**characterized in that**
the at least one back layer (13) is one layer or a stack of layers forming a back surface field or a back emitter of the solar cell (1), wherein a part of said at least one back layer (13) overlaps the edge (19), and wherein a part of said at least one back layer (13) overlaps the at least one front layer (12), and said electrically conductive anti-reflection coating (14) covers the whole surface of the at least one front layer (12).

2. Hetero-junction solar cell of claim 1, **characterized in that** the conductive back coating (15) has a distance of 5 µm to 10 mm from the edge (19) of the semiconductor substrate (11).

3. Hetero-junction solar cell of claim 2, **characterized in that** the conductive back coating (15) has a distance of 30 µm to 3 mm from the edge (19) of the semiconductor substrate (11).

4. Hetero-junction solar cell of one of the preceding claims, **characterized in that** a front transparent conductive film forming the anti-reflection coating (14) of the solar cell (1) is not structured.

5. Hetero-junction solar cell of one of the preceding claims, **characterized in that** the solar cell (1) comprises a back electrode (22) being a metalized back side of the conductive back coating (15).

6. Hetero-junction solar cell of one of the preceding claims, **characterized in that** a horizontal structure of an n-/p-/n-layer stack or of a p-/n-/p-layer stack, acting as two diodes in opposition that block current flow in lateral direction, is formed on the cell edge of the hetero-junction solar cell (1).
